(19) Europäisches Patentamt
European Patent Office
Office européen des brevets

(11) EP 4 528 293 A1

(12) EUROPEAN PATENT APPLICATION

(43) Date of publication:
26.03.2025 Bulletin 2025/13

(21) Application number: 23198600.1

(22) Date of filing: 20.09.2023

(51) International Patent Classification (IPC):
G01R 31/08 $^{(2020.01)}$

(52) Cooperative Patent Classification (CPC):
G01R 31/086; H02J 3/36

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(71) Applicant: General Electric Technology GmbH
5400 Baden (CH)

(72) Inventors:
• KUMAR, Amit
Stafford, ST16 1WS (GB)
• ADAMCZYK, Andrzej
Stafford, ST16 1WS (GB)
• ZOU, Li
Stafford, ST16 1WS (GB)

(74) Representative: Openshaw & Co.
8 Castle Street
Farnham, Surrey GU9 7HR (GB)

(54) **DETECTING A FAULT IN A HIGH VOLTAGE DIRECT CURRENT POWER TRANSMISSION SYSTEM**

(57) There is provided a method and apparatus for detecting a fault close to a grounding circuit in a high voltage direct current (HVDC) power transmission system. The HVDC power transmission system comprises a first converter device having a first terminal and a second terminal, a second converter device having a third terminal and a fourth terminal, a transmission cable connecting the first terminal of the first converter device with the third terminal of the second converter device, and a neutral line connecting the second terminal of the first converter device with the fourth terminal of the second converter device. The method comprises the steps of: generating an alternating current signal by a source converter device, such that a major portion of the generated alternating current signal flows through a direct current circuit (DC, circuit) comprising a stray capacitance associated with the transmission cable and a return path. The source converter device may be either of the first converter device or the second converter device. The source converter device is located electrically close to the grounding circuit. The method further comprises the steps of measuring current at a plurality of points in the power transmission system and detecting a fault electrically close to the grounding circuit based on the measured currents.

500

506
505
501
502
510
530
520

Figure 5

**Description**

Field

The subject matter herein relates generally to the field of power transmission networks and more specifically to detecting a fault in power transmission systems or networks.

Introduction

In high voltage direct current (HVDC) power transmission networks, alternating current (AC) power is typically converted to direct current (DC) power for transmission via overhead lines, under-sea cables and/or underground cables. This conversion removes the need to compensate for the AC reactive/capacitive load effects imposed by the power transmission medium, i.e. the transmission line or cable, and reduces the cost per kilometer of the lines and/or cables, and thus becomes cost-effective when power needs to be transmitted over a long distance. DC power can also be transmitted directly from offshore wind parks to onshore AC power transmission networks, for instance.

The conversion between DC power and AC power is utilised where it is necessary to interconnect DC and AC networks. In any such power transmission network, power conversion means also known as converters (i.e. power converters in converter stations) are required at each interface between AC and DC power to effect the required conversion from AC to DC or from DC to AC.

The choice of the most suitable HVDC power transmission network or scheme depends on the particular application and scheme features. Examples of power transmission networks include monopole power transmission networks and bipole power transmission networks.

There remains an ongoing need for further developments of fault detection methods and apparatus in this area.

Summary

According to a first aspect of the invention there is provided a method for detecting a fault close to a grounding circuit in a high voltage direct current, HVDC, power transmission system, wherein the HVDC power transmission system comprises a first converter device having a first terminal and a second terminal, a second converter device having a third terminal and a fourth terminal, a transmission cable connecting the first terminal of the first converter device with the third terminal of the second converter device, and a neutral line connecting the second terminal of the first converter device with the fourth terminal of the second converter device, the method comprising the steps of: generating an alternating current, AC, signal by a source converter device, such that a major portion of the generated alternating current signal flows through a direct current circuit (DC circuit) comprising a stray capacitance associated with the transmission cable and at least one return path, wherein the source converter device is either of the first converter device or the second converter device, wherein the source converter device is located electrically close to the grounding circuit; measuring a respective current at each of a plurality of points in the HVDC power transmission system; and detecting a fault electrically close to the grounding circuit based on the measured currents.

In some embodiments, the return path includes the stray capacitance of the neutral line and the grounding circuit under normal condition.

In some embodiments, the return path includes the stray capacitance of the neutral line, the grounding circuit, and one or more unintended ground paths under a fault condition.

In some embodiments, the neutral line is a dedicated metallic return.

In some embodiments, the alternating current signal is a high frequency signal having a frequency of $f=1/(2\pi\sqrt{LC})$, where L is a lumped inductance of the source converter device that generates the AC signal and the transmission cable, and C is a lumped capacitance to ground of the transmission cable.

In some embodiments, the alternating current is periodically generated for a pre-defined time interval.

In some embodiments, the plurality of points in the HVDC power transmission system include the transmission cable, the neutral line, the grounding circuit, or a first neutral area of the source converter device.

In some embodiments, a fault in the neutral line is detected based on a ratio of the measured currents in the neutral line and the grounding circuit.

In some embodiments, a fault in the first neutral area is detected based on a sum of at least the measured currents in the transmission cable, the neutral line and the grounding circuit.

In some embodiments, the HVDC power transmission system further comprises a third converter device and a fourth converter device arranged in a bipolar circuit with the first converter device and second converter device.

In some embodiments, the current is measured at a second neutral area associated with the third converter device or fourth converter device.

In some embodiments, a fault in the first neutral area or the second neutral area is detected based on the measured current in the first neutral area and the second neutral area.

In some embodiments, one or more of the measured currents is a harmonic current.

In some embodiments, the method further comprises the step of performing a protective action upon detecting the fault.

According to a second aspect of the invention, there is provided an apparatus for detecting a fault close to a grounding circuit in a high voltage direct current, HVDC, power transmission system, wherein the HVDC power transmission system comprises a first converter device having a first terminal and a second terminal, a second converter device having a third terminal and a fourth terminal, a transmission cable connecting the first terminal of the first converter device with the third terminal of the second converter device, and a neutral line connecting the second terminal of the first converter device with the fourth terminal of the second converter device, the apparatus comprising: a means for generating an alternating current signal by a source converter device, such that a major portion of the generated alternating current signal flows through a direct current circuit (DC circuit) comprising a stray capacitance associated with the transmission cable and at least one return path, wherein the source converter device is either of the first converter device or the second converter device, wherein the source converter device is located electrically close to the grounding circuit; a means for measuring current at a plurality of points in the HVDC power transmission system; and a means for detecting a fault electrically close to the grounding circuit based on the measured currents.

In some embodiments, the return path includes the stray capacitance of the neutral line and the grounding circuit under normal condition.

In some embodiments, the return path includes the stray capacitance of the neutral line, the grounding circuit, and one or more unintended ground paths under a fault condition.

In some embodiments, the neutral line is a dedicated metallic return.

In some embodiments, the alternating current signal is a high frequency signal having a frequency of $f=1/(2\pi\sqrt{LC})$, where L is a lumped inductance of the source converter device that generates the AC signal and the transmission cable, and C is a lumped capacitance to ground of the transmission cable.

In some embodiments, the alternating current is periodically generated for a pre-defined time interval.

In some embodiments, the plurality of points in the HVDC power transmission system include the transmission cable, the neutral line, the grounding circuit, or a first neutral area of the source converter device.

In some embodiments, a fault in the neutral line is detected based on a ratio of the measured currents in the neutral line and the grounding circuit.

In some embodiments, a fault in the first neutral area is detected based on a sum of at least the measured currents in the transmission cable, the neutral line and the grounding circuit.

In some embodiments, the HVDC power transmission system further comprises a third converter device and a fourth converter device arranged in a bipolar circuit with the first converter device and second converter device.

In some embodiments, the current is measured at a second neutral area associated with the third converter device or fourth converter device.

In some embodiments, a fault in the first neutral area or the second neutral area is detected based on the measured current in the first neutral area and the second neutral area.

In some embodiments, one or more of the measured currents is a harmonic current.

In some embodiments, the apparatus further comprises the step of performing a protective action upon detecting the fault.

According to a third aspect of the invention, there is provided a computer program comprising instructions for causing an apparatus to perform at least: any method as described with reference to the first aspect.

According to a fourth aspect, there is provided a non-transitory computer readable medium comprising program instructions for causing an apparatus to perform at least: any method as described with reference to the first aspect.

According to a fifth aspect, there is provided an apparatus comprising: at least one processor and at least one memory comprising code that, when executed by the at least one processor, causes the apparatus to perform (at least) any method as described with reference to the first aspect.

According to a sixth aspect of the invention, there is provided a controller for a converter device, comprising: a memory; and at least one processor; wherein the memory comprises computer-readable instructions which when executed by the at least one processor cause the controller to perform (at least) any method as described with reference to the first aspect.

It will also be appreciated that the use of the terms "first" and "second", and the like, are merely intended to help distinguish between similar features (for instance the first and second converter devices) and are not intended to indicate a relative importance of one feature over another, unless otherwise specified.

Within the scope of this application it is expressly intended that the various aspects, embodiments, examples and alternatives set out in the preceding paragraphs, and the claims and/or the following description and drawings, and in particular the individual features thereof, may be taken independently or in any combination. That is, all embodiments and all features of any embodiment can be combined in any way and/or combination, unless such features are incompatible. The applicant reserves the right to change any originally filed claim or file any new claim accordingly, including the right to amend any originally filed claim to depend from and/or incorporate any feature of any other claim although not originally claimed in that manner.

Brief description of the drawings

Embodiments of the invention will now be described by way of example only and with reference to the accompanying drawings, in which:

Figure 1 illustrates generically, an example of a power transmission network.

Figure 2 illustrates an embodiment of a controller as may be used in implementing the invention described herein.

Figure 3 shows a power transmission system, according to an example embodiment.

Figure 4 shows power transmission system, according to one or more example embodiments.

Figure 5 shows an apparatus, according to an embodiment.

Figure 6 is a flow diagram showing processing operations, according to one or more example embodiments.

Figure 7 shows a power transmission system, according to one or more example embodiments.

Figure 8 shows a bipole power transmission network, according to an embodiment.

Figure 9 is a flow diagram of an algorithm, according to an embodiment.

Detailed description

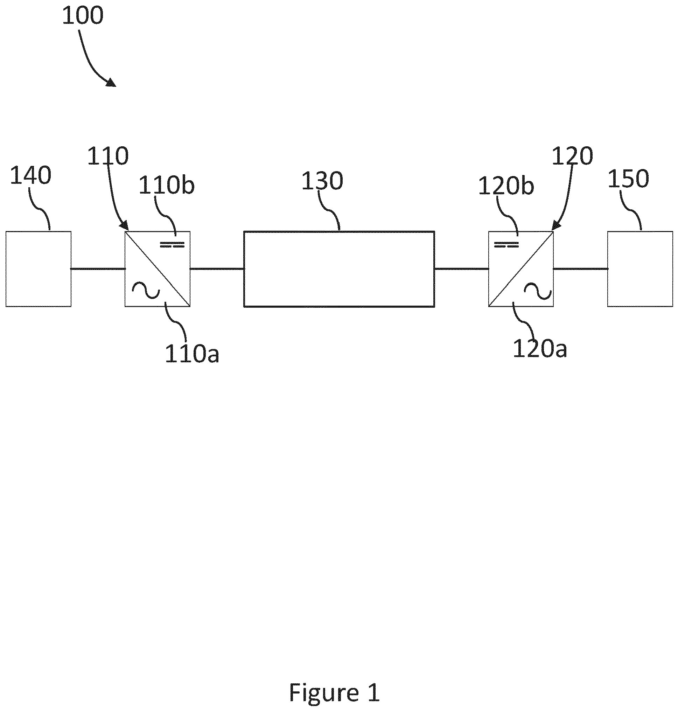

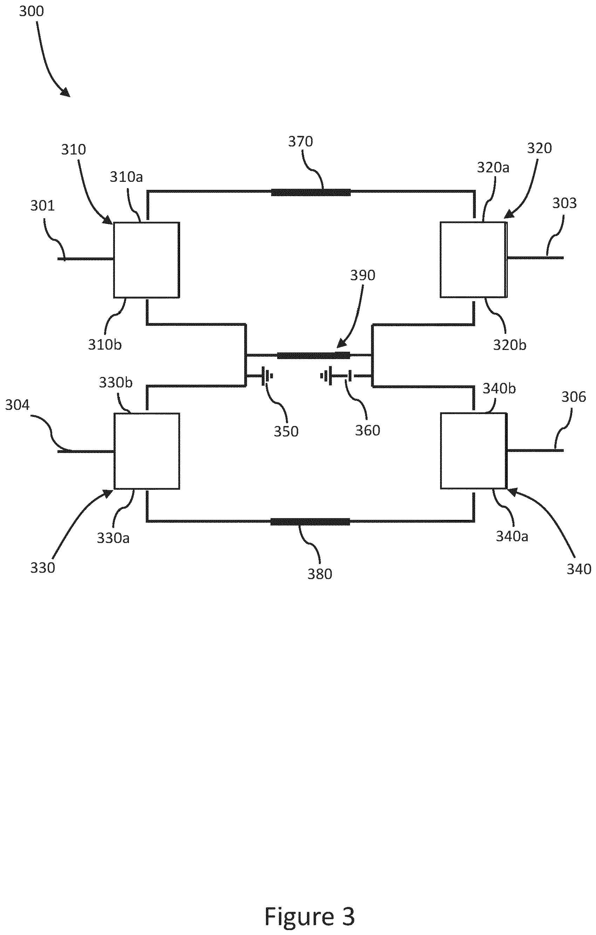

Figure 1 illustrates generically, an example of a power transmission network 100. The illustration is not intended to be limited to representing a particular power transmission scheme, such as a monopole or bipole HVDC transmission network, but is moreover provided as a generic example illustrating principles of operation of a power transmission network that are useful for understanding the invention. In this manner, the power transmission network 100 may represent, generically, a monopole or bipole scheme, or may represent a multiterminal power transmission scheme, for instance. Hence whilst specific features in the illustration are shown connected to each other with a specific number of connections, it will be understood that this is not intended to be limiting either, but moreover to illustrate a generic connection between features/components. Related, is that relative dimensions or distances between components perceived in the illustration are also not intended to be limiting. It will therefore be understood that principles and features in the network 100 and herein discussed can be applied to networks of Figures 3, 4, 7 or 8 for instance.

The power transmission network 100 illustrates a first converter device 110 (also known as a first power conversion means 110 or a converter station) and a second converter device 120. The first converter device 110 and second converter device 120, convert AC power to DC power (and vice versa), acting essentially as a rectifier (when converting AC power to DC power for transmission) and an inverter (when receiving DC power and converting to AC power). The first converter device 110 and second converter device 120, may each comprise a single converter in the case of a monopole system, or two converters in the case of a bipole system. The first converter device 110 and second converter device 120 may represent a plurality of converter stations arranged as a multi-terminal power transmission system. Generically, the first converter device 110 comprises a first AC side 110a and a first DC side 110b. Generically, the second converter device 120 comprises a second AC side 120a and a second DC side 120b.

The first converter device 110 is illustrated as being connected to a first AC network 140. The first AC network 140 is illustrated as being connected to the first AC side 110a of the first converter device 110.

The second converter device 120 is illustrated as being connected to a second AC network 150. The second AC network 150 is illustrated as being connected to the second AC side 120a of the second converter device 120. The first AC network 140 and/or second AC network 150 may be electrical power transmission systems comprising power generation apparatus, transmission apparatus, distribution apparatus, and electrical loads. The first AC network 140 and/or second AC network 150 may comprise a renewable power generation network such as a wind-power generation network, solar-power generation network, bio-power generation network. The first AC network 140 or second AC network 150 may be a consumer network. Byway of non-limiting example, the first AC network 140 may be a power generation network, with second AC network 150 being a consumer network, for instance.

Also illustrated is a power transmission medium 130 interconnecting the first converter device 110 and second converter device 120. The power transmission medium 130 is connected between the first DC side 110b of first converter device 110 and the second DC side 120b of the second converter device 120. The power transmission medium 130 may comprise electrical cables and other electrical components interconnecting the first converter device 110 and second converter device 120. For instance, the power transmission medium 130 may comprise a conductor providing a first electrical pole; and/or a conductor providing a second electrical pole. A neutral arrangement may also be provided interconnecting the first converter device 110 and second converter device 120. The power transmission medium 130 provides the medium through which DC power is transmitted between the first converter device 110 and second converter device 120.

The operation of the power transmission system 100 can be generically described as follows. The first AC power generation network 140 generates AC power that is provided to first converter device 110 at the first AC side 110a. The first converter device 110 converts the received AC power to a DC power for transmission to second power conversion means 120. The DC power is transmitted from first DC side 110b over the power transmission medium 130 to the second DC side 120b of second converter device 120. The second converter device 120 converts the received DC power back to an AC power. The AC power is then provided from second AC side 120a to second AC network 150 for consumption, for instance. In particular examples, the first converter device 110 and second converter device 120 may be geographically remote. For instance, the first converter device 110 may reside with an off-shore wind farm and the second converter device 120 may reside on-shore.

It will be appreciated that various other electrical components may be located at any particular location or with any particular feature/component in the example 100. These may include switches, transformers, resistors, reactors, surge arrestors, harmonic filters and other components well known in the art.

It will be appreciated that converters or power conversion means may comprise a number of different technologies such as voltage sourced converters (for instance using insulated gate bipolar transistor (IGBT) valves). Such converters may generally be considered to use 'power electronics'. Power electronic converters may comprise multi-level voltage sourced converters, for instance.

It will be appreciated that cables used as power transmission mediums may comprise the following non-limiting examples of crosslinked polyethylene (XLPE) and/or mass impregnated (MI) insulation cables. Such cables may comprise a conductor (such as copper or Aluminium) surrounding by a layer of insulation. Dimensions of cables and their associated layers may be varied according to the specific application (and in particular, operational voltage requirements). Cables may further comprise strengthening or 'armouring' in applications such as subsea installation. Cables may further comprise sheaths/screens that are earthed at one or more locations.

Moreover, it will be understood that the power transmission network 100 may be used with three-phase power systems. In a three-phase power system, three conductors supply respective first, second and third phases of AC power to a consumer. Each of the first, second and third phases will typically have equal magnitude voltages or currents, which are displaced in phase from each other by 120°.

In a three-phase power system, phase currents and voltages can be represented by three single phase components: a positive sequence component; a negative sequence component; and a zero-sequence component. It is the positive sequence component that rotates in phase in accordance with the power system. Hence, in the idealistic scenario, only positive sequence voltage/current will exist. It will be understood that an unbalance in voltage or current between the first, second and third-phases, of a three-phase system, in magnitude or phase angle, can give rise to undesirable negative or zero-sequence components. Such an unbalance can be caused by fault conditions, for instance in the AC networks 140, 150.

The power transmission network 100 may be operated using methods such as synchronous grid forming (SGFM) wherein either or both of the first converter device 110 and second converter device 120 behave as three-phase, positive-phase sequence AC voltage sources behind an impedance, that operate at a frequency synchronous with other SGFM sources connected to the power transmission network 100.

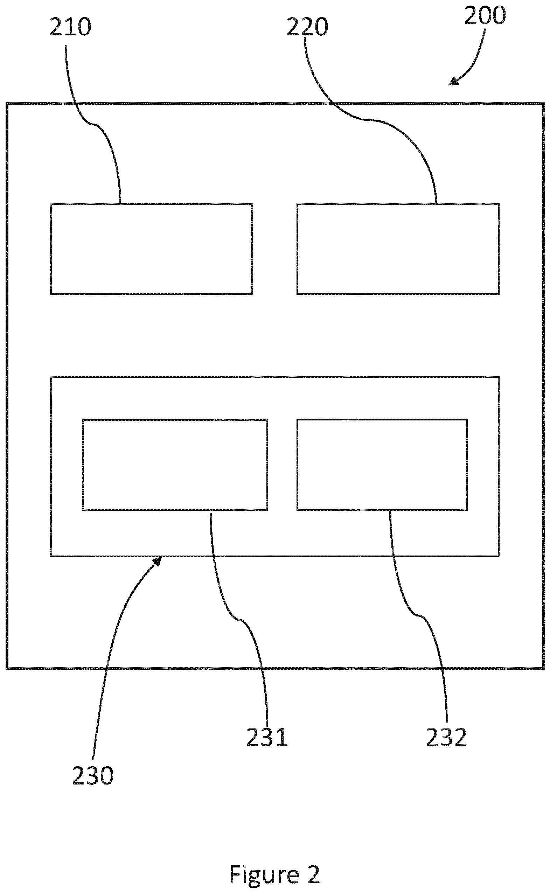

The power transmission network 100 may further comprise a controller for controlling the operation of components of the power transmission network 100. For instance, a controller may be provided for executing the methods described herein. Such a controller may control the first converter device 110 or second converter device 120, for instance. Such a controller may be referred to as a controller means or control means. The controller may be the controller 200 of Figure 2.

Figure 2 illustrates an embodiment of a controller 200 as may be used in implementing the invention described herein.

The controller 200 comprises a memory 210 and at least one processor 220. The memory 210 comprises computer-readable instructions, which when executed by the at least one processor 220, cause the controller 200 to perform the method/s described herein.

The controller 200 is illustrated as comprising a transceiver arrangement 230 which may comprise a separate transmitter 231 and receiver 232. The transceiver arrangement 230 may be used to operatively communicate with other components or features of embodiments described herein either directly or via a further interface such as a network interface. The transceiver arrangement 230 may for instance send and receive control signals using transmitter 231 and receiver 232. The control signals may contain or define electrical control parameters such as reference currents or reference voltages.

The at least one processor 220 is capable of executing computer-readable instructions and/or performing logical operations. The at least one processor 220 may be a microcontroller, microprocessor, central processing unit (CPU), field programmable gate array (FPGA) or similar programmable controller. The controller may further comprise a user input device and/or output device. The processor 220 is communicatively coupled to the memory 210 and may in certain embodiments be coupled to the transceiver 230.

The memory 210 may be a computer readable storage medium. For instance, the memory 210 may include a non-volatile computer storage medium. For example, the memory 210 may include a hard disk drive, flash memory etc.

Whilst not illustrated, the controller 200 may additionally include a user input device interface and/or a user output device interface, which may allow for visual, audible or haptic inputs/outputs. Examples include interfaces to electronic displays, touchscreens, keyboards, mice, speakers and microphones.

Figure 3 shows a power transmission system, indicated generally by reference numeral 300, according to an example embodiment. The power transmission system 300 may represent a bipole scheme or a multi-terminal power transmission scheme. For example, a rigid bipole scheme or a bipole scheme with a dedicated metallic return. In some embodiments, the power transmission system 300 is a HVDC power transmission system.

The power transmission system 300 comprises a first converter device 310 having a first terminal 310a and a second terminal 310b and a second converter device 320 having a third terminal 320a and a fourth terminal 320b. A first transmission cable 370 is arranged to connect the first terminal 310a of the first converter device 310 with the third terminal 320a of the second converter device 320. A neutral line 390 connects the second terminal 310b of the first converter device 310 with the fourth terminal 320b of the second converter device 320. The first terminal 310a and third terminal 320a may be HVDC terminals; for example, positive or negative HVDC terminals. The second terminal 310b and fourth terminal 320b may be neutral DC terminals. The first converter device 310 and second converter device 320 may be connected to a first AC grid 301 and a second AC grid 303, respectively.

In the case of a bipole scheme, the power transmission system 300 may further comprise a third converter device 330 having a fifth terminal 330a and a sixth terminal 330b and a fourth converter device 340 having a seventh terminal 340a and an eighth terminal 340b. A second transmission cable 380 is arranged to connect the fifth terminal 330a of the third converter device 330 with the seventh terminal 340a of the fourth converter device 340. The neutral line 390 connects the sixth terminal 330b of the third converter device 330 with the eighth terminal 340b of the fourth converter device 340. The fifth terminal 330a and seventh terminal 340a may be HVDC terminals; for example, positive or negative HVDC terminals. The sixth terminal 330b and eighth terminal 340b may be neutral DC terminals. The third converter device 330 and fourth converter device 340 may be connected to a third AC grid 304 and a fourth AC grid 306, respectively. The third AC grid 304 may be the same as the first AC grid 301. The fourth AC grid 306 may be the same as the second AC grid 303. In some example embodiments, the neutral line 390 comprises a dedicated metallic return.

The power transmission system 300 further comprises a first converter station and a second converter station. The first converter station may have the first converter device 310 (and third converter device 330 in a bipole scheme). The second converter station may have the second converter device 320 (and the fourth converter device 340 in a bipole scheme).

In some example embodiments, one of the first converter station or the second converter station is permanently grounded through a first grounding circuit 350. The first grounding circuit 350 includes either a solid metallic connection or a substantially small resistance/impedance.

In some example embodiments, the other of the first converter station or the second converter station is grounded either through a second grounding circuit 360 or ungrounded. The second grounding circuit 360 includes a neutral arrester (for example, a neutral arrester comprising a substantially very high impedance).

In some example embodiments, at least one of the first grounding circuit 350 or the second grounding circuit 360 is disconnectable from the power transmission system 300 such that it may be grounded when the station needs to be operated in Static Synchronous Compensator (STATCOM) mode (for example, to provide reactive power compensation) or balanced bipolar mode (for example, during unavailability of a dedicated metallic return 390).

The first transmission cable 370 may have a high potential with respect to the first grounding circuit 350 or the second grounding circuit 360. A high potential may be the rated DC voltage of the scheme; for example, 300 kV - 600 kV DC. The second transmission cable 380 may have a high potential with respect to the first grounding circuit 350 or the second grounding circuit 360.

The first transmission cable 370 may be configured as a first pole. The second transmission cable 380 may be configured as a second pole. The first pole may have an opposite polarity to the second pole; for example, the first pole may be a positive pole and the second pole may be a negative pole or vice versa.

The first transmission cable 370 may comprise a stray capacitance associated with the first transmission cable 370. Similarly, the second transmission cable 380 may comprise a stray capacitance associated with the second transmission cable 380. If a fault develops in one of the first transmission cable 370 or second transmission cable 380, then the power transmission system 300 may be configured to switch to a monopole mode. For example, if a fault develops in the first transmission cable 370, the power transmission system 300 may continue to transmit power via the second transmission cable 380, or vice versa.

In some example embodiments, one or more of the first converter device 310, second converter device 320, third converter device 330 or fourth converter device 340 may be a voltage sourced converter (VSC).

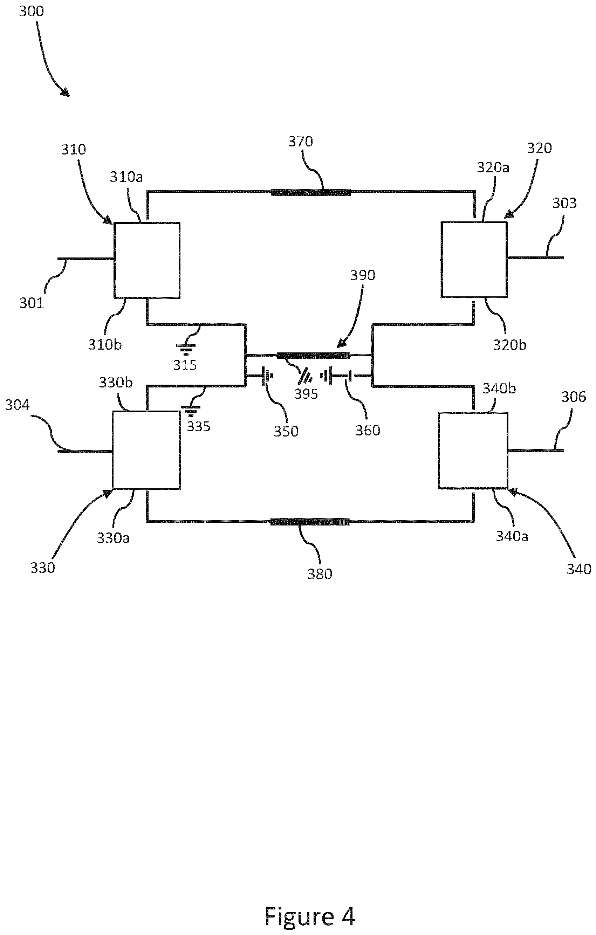

Figure 4 shows power transmission system 300 according to one or more example embodiments. The power transmission system 300 may experience a fault condition close to the grounding circuit. For example, a first neutral fault 315 may occur in the first neutral area of the first converter device 310. The power transmission system 300 may experience a second neutral fault 335 in a second neutral area of the third converter device 330. The power transmission system 300 may experience a first neutral line fault 395 on the neutral line 390. The first neutral fault 315, second neutral fault 335 or first neutral line fault 395 may be electrically close to a grounded converter device. The first neutral fault 315, second neutral fault 335 or first neutral line fault 395 result in a fault condition in the DC circuit.

In some example embodiments, the power transmission system 300 may be unable to detect the first neutral fault 315 or the second neutral fault 335 in either monopole or bipole mode. This may be because there may be substantially zero fault current and the power transmission system 300 may continue operation without identifying the fault. Although this may not be an immediate risk to the power transmission system 300, a subsequent DC circuit fault may result in transient currents. It may be desirable to remove the transient currents by detecting and neutralizing the fault. Furthermore, the first neutral fault 315, second neutral fault 335 or first neutral line fault 395 may pose a risk on an AC main breaker (not shown) as it may cause a delay in zero crossing; for example, in the case of valve winding to ground faults.

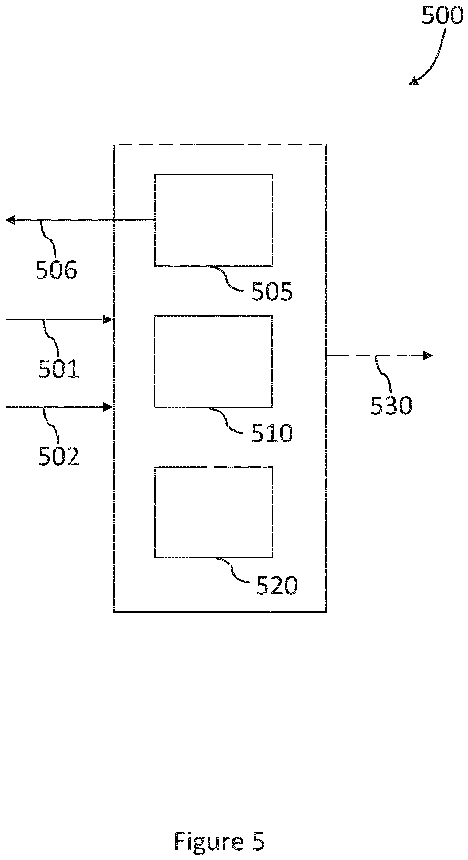

Figure 5 shows an apparatus, indicated generally by reference numeral 500, according to an embodiment. The apparatus 500 may be used for detecting a fault close to a grounding circuit in a power transmission system (for example, a high voltage direct current, HVDC, power transmission system).

The power transmission system (not shown) may be the same or similar to power transmission system 300 described in detail above in relation to Figures 3 and 4. The power transmission system comprises at least one first converter device having a first terminal and a second terminal, at least one second converter device having a third terminal and a fourth terminal, a transmission cable connecting the first terminal of the first converter device with the third terminal of the second converter device, and a neutral line connecting the second terminal of the first converter device with the fourth terminal of the second converter device.

The apparatus 500 comprises a means for generating 505 an AC signal 506. The apparatus 500 may be connected to at least one source converter device. The at least one source converter device is a converter device located close to the grounding circuit, in the vicinity of which fault is to be detected (for example, the source converter device may be the first converter device 310, second converter device 320, the third converter device 330 or fourth converter device 340 described above in relation to in Figure 4). For example, if the fault is to be detected in the vicinity of the first grounding circuit 350, then either the first converter 310 or the third converter 330 may act as the "source converter" and inject the AC current signal 506 to detect the fault.

When connected to the source converter device (not shown), a major portion of the generated AC current signal 506 flows through a DC circuit (associated with the source converter device). The DC circuit (not shown) may comprise a stray capacitance associated with the transmission cable and at least one return path. Thus, the AC current signal 506 injected into the DC circuit by the source converter device flows into the ground through the stray capacitance associated with the transmission cable and then returns to the source converter through the return path. Under normal conditions, the return path may comprise a stray capacitance associated with the neutral line and the grounding circuit. However, when there is a fault close to the grounding circuit such as the first neutral fault 315, second neutral fault 335 or first neutral line fault 395, the return path of the AC current signal 506 changes. In some embodiments, under a fault condition, the return path includes the stray capacitance of the neutral line, the grounding circuit, and one or more unintended ground paths (for example, the unintended ground path may be one or more associated with the first neutral fault 315, second neutral fault 335 or first neutral line fault 395). In some example embodiments, the means for generating 505 is an AC reference signal generator.

The apparatus comprises a means for measuring 510 current at a plurality of points (for example, a first current 501 and a second current 502) in the power transmission system. For example, the means for measuring 510 may be a current sensor.

The apparatus further comprises a means for detecting 520 a fault electrically close to the grounding circuit based on the measured currents (for example, the first current 501 and the second current 502) in the power transmission system. For example, the means for detecting 520 may comprise a processor arranged to detect a fault using an algorithm that performs a calculation using the measured currents; as will be discussed in more detail later.

In some example embodiments, the apparatus may further comprise a means for outputting 530 an indication of a fault detection. The indication may be provided to a user or provided as an input into another computer program or algorithm.

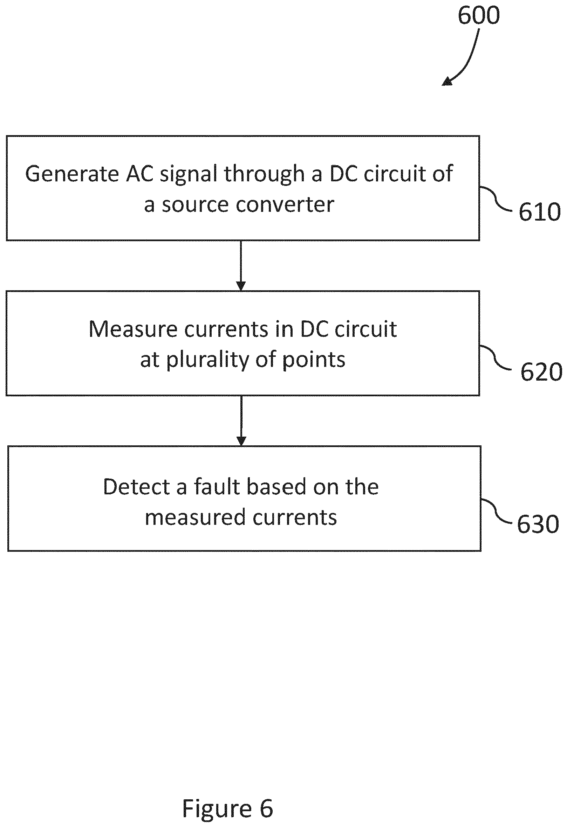

Figure 6 is a flow diagram showing processing operations, indicated generally by reference numeral 600, according to one or more example embodiments. The processing operations 600 may be performed in hardware, software, firmware, or a combination thereof. For example, the processing operations 600 may be performed by apparatus 500 shown in Figure 5.

The processing operations 600 are for detecting a fault close to a grounding circuit in a high voltage direct current, HVDC, power transmission system. The HVDC power transmission system comprises at least one first converter device having a first terminal and a second terminal, at least one second converter device having a third terminal and a fourth terminal, a transmission cable connecting the first terminal of the first converter device with the third terminal of the second converter device, and a neutral line connecting the second terminal of the first converter device with the fourth terminal of the second converter device.

A first operation 610 comprises generating an AC signal by at least one source converter device, such that a major portion of the generated alternating current signal flows through a DC circuit comprising a stray capacitance associated with the transmission cable and at least one return path. Under normal conditions (i.e. no fault in the DC circuit), the return path may comprise a stray capacitance associated with the neutral line and the grounding circuit. For example, the source converter device may be the first converter device 310, second converter device 320, the third converter device 330 or fourth converter device described above in relation to in Figure 4. The source converter device is located electrically close to the grounding circuit (for example, the first grounding circuit 350 or the second grounding circuit 360 described above in relation to Figure 4). The first neutral fault 315, second neutral fault 335 or first neutral line fault 395 result in a fault condition in the power transmission system. In some embodiments, under a fault condition the return path includes the stray capacitance of the neutral line, the grounding circuit, and one or more unintended ground paths (for example, the unintended ground path may be associated with one or more of the first neutral fault 315, second neutral fault 335 or first neutral line fault 395). The AC signal may be generated by a means for generating (such as means for generating 505 described above in relation to Figure 5).

A second operation 620 comprises measuring current at a plurality of points in the power transmission system. The current may be measured by a means for measuring (for example, means for measuring 510 described above in relation to Figure 5).

A third operation 630 comprises detecting a fault electrically close to the grounding circuit based on the measured currents. A fault may be detected using a means for detecting (for example, means for detecting 520 described above in relation to Figure 5).

It should be noted that certain of the process steps depicted in the flow diagram of Figure 6 and described above may be omitted or such process steps may be performed in differing order to that presented above and shown in Figure 6. Furthermore, although all the process steps have, for convenience and ease of understanding, been depicted as discrete temporally-sequential steps, nevertheless some of the process steps may in fact be performed simultaneously or at least overlapping to some extent temporally.

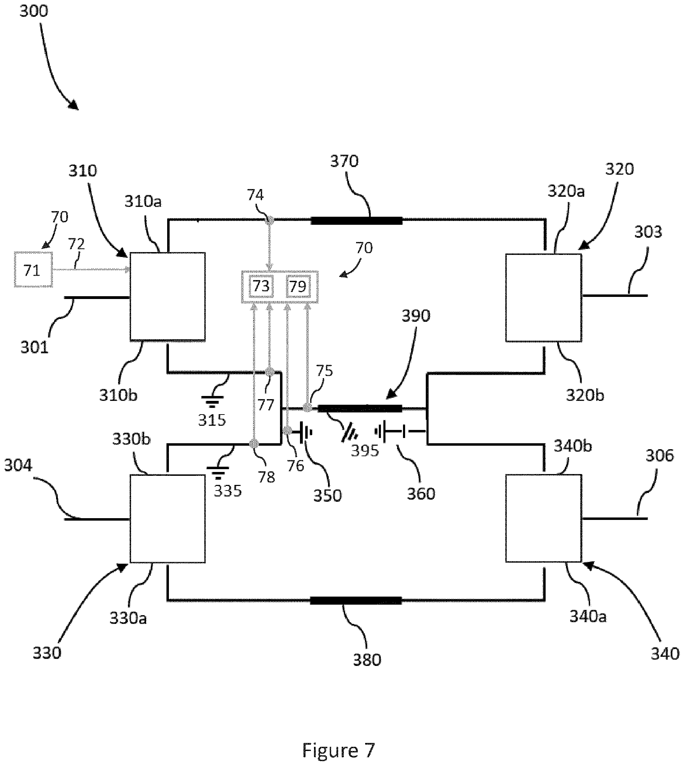

Figure 7 shows a power transmission system 300, according to one or more example embodiments. The power transmission system 300 may further comprise a first neutral fault 315 in the first neutral area of the first converter device 310 (which may or may not be the source converter device). The power transmission system 300 may comprise a second neutral fault 335 in the second neutral area of the third converter device 330 (which may or may not be the source converter device). The power transmission system 300 may comprise a first neutral line fault 395. The first neutral fault 315, second neutral fault 335 or first neutral line fault 395 may be electrically close to a grounded converter device.

It will be appreciated that the first neutral fault 315, second neutral fault 335 or first neutral line fault 395 are shown only as examples and the power transmission system 300 may be unable to detect a neutral fault in other parts of the power transmission system 300.

Figure 7 further shows an apparatus 70 for detecting a fault close to the first grounding circuit 350 in the power transmission system 300. The apparatus 70 may be the same or similar to apparatus 500 described above in relation to figure 5.

The apparatus 70 comprises a means for generating 71 a reference AC signal 72. The means for generating 71 is arranged to direct the reference AC signal 72 into the first converter device 310 (which in this example is the source converter device), such that a major portion of the generated AC signal based on the reference AC signal 72 flows through the DC circuit. The DC circuit comprises the a stray capacitance associated with the first transmission cable 370 and at least one return path. Under normal conditions, the return path includes the stray capacitance associated with the neutral line 390 and the first grounding circuit 350. The source converter device 310 is located electrically close to the first grounding circuit 350.

The apparatus 70 further comprises a means for measuring 73 current at a plurality of points in the power transmission system. In Figure 7, the current is shown as being measured at five points in the power transmission system. At a first point 74, the current is measured in the first transmission cable 370. At a second point 75, the current is measured in the neutral line 390. At a third point 76, the current is measured in the first grounding circuit 350. At a fourth point 77, the current is measured in a first neutral area of the first (source) converter device 310. At a fifth point 78, the current is measured in a second neutral area of the third converter device 330.

In some embodiments, one or more of the measured currents are harmonic currents. In some embodiments, one or more of the measured currents are high harmonic currents; for example, greater than the 4th order harmonic.

The first neutral line fault 395 may be detected based on a ratio of the measured currents in the neutral line 390 and the first grounding circuit 350 i.e. a ratio of the measured currents at the second point 75 and the third point 76.

The first neutral fault 315 may be detected based on a sum of at least the measured currents in the first transmission cable 370, the neutral line 390 and the grounding circuit 350 i.e. a sum of the measured currents at the first point 74, the second point 75 and the third point 76.

The first neutral fault 315 or second neutral fault 335 may be detected based on the measured current in the first neutral area and the second neutral area i.e. the measured currents at the fourth point 77 and fifth point 78.

In some example embodiments, the reference AC signal 72 is a high frequency signal having a frequency of f= 1 /(2π√LC), where L is a lumped inductance of the converter device that generates the alternating current signal and the transmission cable, and C is a lumped capacitance to ground of the transmission cable.

In some example embodiments, the reference AC signal 72 is periodically generated for a pre-defined time interval. For example, the reference AC signal 72 may be generated for a few milliseconds or a few seconds in one instance. For example, the reference AC signal 72 may be repeated every hour.

In some example embodiment, the apparatus 70 is further configured to perform a protective action upon detecting the fault. For example, the protective action may include an alarm generated to the operator and/or protective action to isolate the faulty part.

It is to be understood that the measurement points shown in Figure 7 are made purely as an example and it may be possible for the apparatus 70 to measure currents at other locations in the power transmission network 300. The measurement points may depend on the scheme of the power transmission network (for example, asymmetric monopole, bipole with a dedicated metallic return or rigid bipole), the number of power converter devices, the source power converter device, the source converter device, the location of a fault.

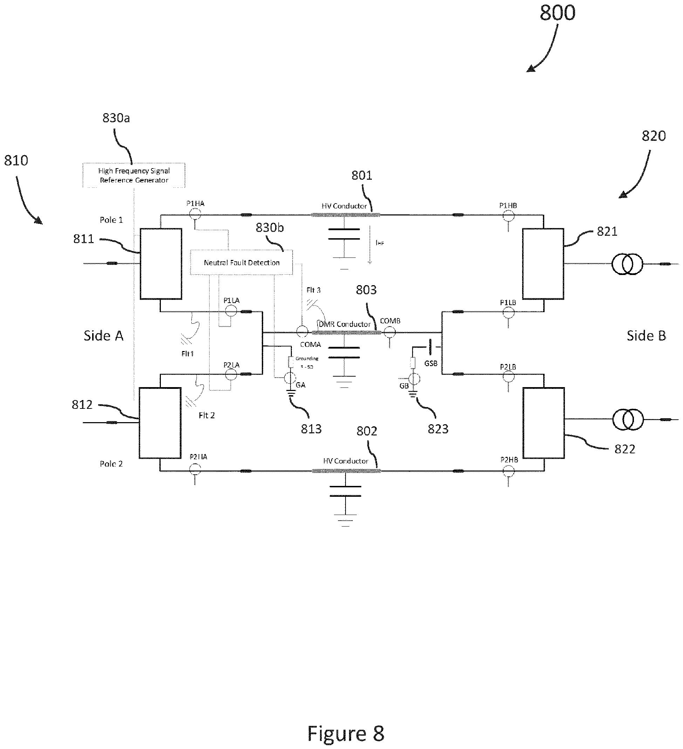

Figure 8 shows a bipole power transmission network, indicated generally by reference numeral 800, according to an embodiment.

The bipole power transmission network 800 comprises a side A 810 and a side B 820. Side A 810 comprises a first converter device 811, a third converter device 812. Side B 820 comprises a second converter device 821 and a fourth converter device 822. A HV conductor 801 (pole 1) connects the first converter device 811 to the second converter device 821. A second HV conductor 802 (pole 2) connects the third converter device 812 to the fourth converter device 822. The bipole power transmission network 800 further comprises a dedicated metallic return (DMR) conductor 803 but may instead be a rigid bipole scheme.

Side A 810 is permanently grounded by a first grounding circuit 813; for example, either solidly or through a small resistance/impedance. Side B 820 is grounded by a second grounding circuit 823; for example, either grounded through neutral arrester (for example, using a very high impedance) or ungrounded. Side B 820 is typically provided with a disconnectable grounding circuit, so that it can be grounded when the station needs to be operated in STATCOM mode or balanced bipolar mode during DMR conductor unavailability.

A neutral fault or a fault in the occurring in the DMR conductor 803 close to the first grounding circuit 813 or second grounding circuit 823 may occur; for example Flt1, Flt2 or Flt3 as shown in Figure 8. These types of faults may not typically be detected based on a fault current or disruption to operation of the bipole power transmission network 800. Although this does not pose any immediate risk to the bipole power transmission system 800, a subsequent DC circuit fault might result in unacceptable transient currents, that would not occur if the neutral area fault was identified and neutralized. Further, the solid fault at neutral impose risk on the AC main breaker, as there could be delay in zero crossing in case of valve winding to ground faults.

Figure 8 further shows apparatus 830 (high frequency signal reference generator 830a and neutral fault detection 830b) which may be part of a protection system to detect a converter station neutral fault. This type of apparatus may improve maintainability and availability of the bipole power transmission network 800 or similar networks.

The high frequency signal reference generator 830a may be a means for generating an AC signal which may be the same as or similar to the means for generating 505 in Fig. 5 or means for generating 71 in Fig. 7. The neutral fault detection 830b may comprise a means for measuring current which may be the same as or similar to means for measuring 510 in Fig. 5 or means for measuring 73 in Fig. 7. The neutral fault detection 830b may comprise a means for detecting a fault which may be the same or similar to means for detecting 520 in Fig. 5 or means for detecting 79 in Fig. 7.

The high frequency signal reference generator 830a creates a common mode high frequency voltage signal in at least one of the pole converters, for a pre-defined period automatically every pre-defined interval, which drive a high frequency current in the DC circuit, in order to detect a neutral ground fault at a grounded station.

The frequency of the AC component voltage/-current signal may be chosen in such a way that maximum current flow through the HV conductor capacitance to ground, i.e., the impedance offered by the current path from converter to ground through HV conductor capacitance is minimum.

Based on the known lumped inductance (converter + transmission cable) and lumped capacitance, one can calculate/select/estimate the frequency at which the maximum of high frequency current flow to ground through cable capacitance, by using following formula,

$$f = \frac{1}{2\pi\sqrt{LC}}$$

where L is the lumped inductance of converter and transmission cable, which is in intended path of high frequency current and C is the lumped capacitance to ground.

The frequency of the high frequency signal can be determined based on the above formula, and/or through the hit and trial EMT simulation of the circuit.

A large proportion (Most) of this high frequency current will circulate through the pole HV conductor parasitic capacitance to ground. This is because the effective shunt impedance of the bipole power transmission network 800 is inversely proportional to the frequency of the current. For illustration, the HV conductor (i.e. the first HV 801 and DMR cable (s) can be represented as lumped capacitance, as shown in Figure 8. If the system is healthy (i.e. does not have a fault), this current will loop back to the source converter partly through the grounding circuit and partly through the DMR circuit. Moreover, for a given system, the ratio of harmonic current flow through the grounding circuit to the flow through the DMR is determined by the harmonic impedance profile of those circuits and hence it is known, as designed. The presence of a ground fault in the neutral area may disrupt this natural harmonic current flow pattern in a characteristic way for each of the considered fault locations (Flt1, Flt2 and Flt3).

The high frequency signal reference is intentionally generated, so it can flow to the ground through the parasitic capacitance of DC transmission cables, then monitor its return paths at neutral to identify the faults. The current may enter in ground first such that a ground fault in the return path may be identified. This may be because such a fault may provide an additional return path for this current and thus will disturb the distribution of this current through the normal return paths.

The neutral fault detection 830b is configured to measure the current at point P1HA connected to the first HV conductor 801, point COMA connected to the DMR conductor 803, point GA at the first grounding circuit 813, point P1LA at a first neutral circuit of the first converter device 811 and point P2LA at a second neutral circuit of the third converter device 812. One or more of points P1HA, COMA, GA, P1LA or P2LA may be arranged to measure the current at the terminals of the first converter device 811 i.e. where the respective cable connects to the first converter device 811.

Faults Flt1 and Flt2 are located between the neutral current measurement points, P1LA and P2LA respectively, and their corresponding HVDC converters neutral terminals. When there is no neutral fault of this type then the sum of high harmonics current at P1HA, P1LA (which is the sum of COMA and GA) may be practically zero, and if there is fault then this may be non-zero. Hence, the neutral fault detection 830b may detect the fault if the sum of harmonics current in P1HA, COMA and GA increases above a threshold.

Further, based on the measured harmonics current at P1LA and P2LA, it may be detected if the fault is in pole 1 neutral or pole 2 neutral. Specifically, assuming that harmonic current is sourced from pole 1 converter and that the fault occurred in the neutral area of pole 1, Flt1, then point P2LA (~ Zero) will measure a small proportion of the harmonic current. If the fault was in the neutral area of pole 2, Flt2, then P2LA will measure a significant proportion of the circulated harmonic current.

Finally, if the fault occurred in the DMR circuit, Flt3, although the net sum of harmonic currents measured by points P1HA, COMA and GA would be practically zero, but the ratio of currents measured by points COMA, and GA would be significantly different from the one expected for the healthy system. The current ratio difference may be higher the closer is the fault location to the grounding circuit.

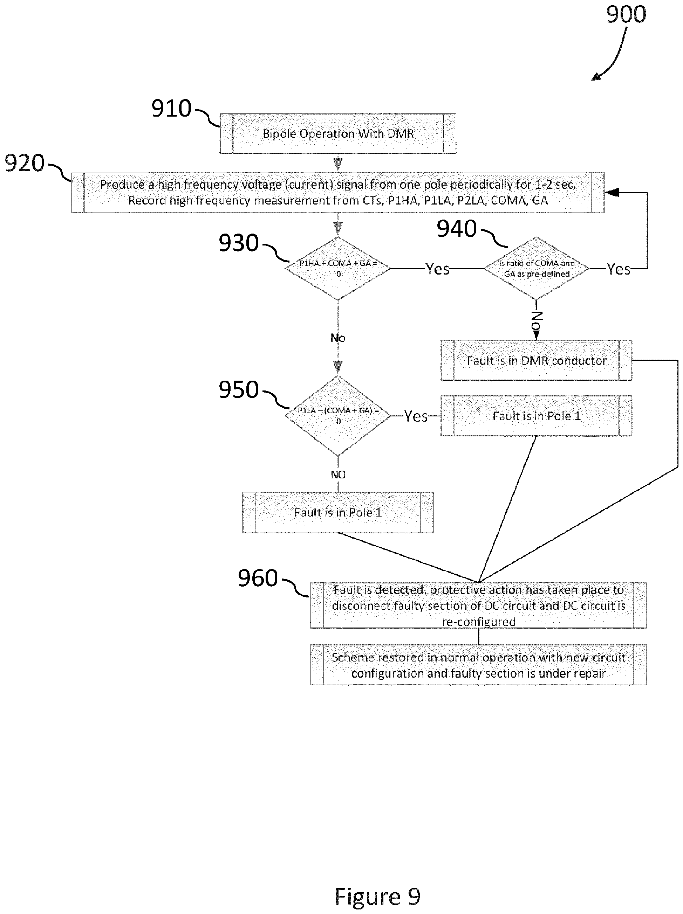

Figure 9 is a flow diagram of an algorithm, indicated generally by reference numeral 900, according to an embodiment. The algorithm 900 may be performed in hardware, software, firmware, or a combination thereof. For example, the algorithm 900 may be performed by apparatus 830 shown in Figure 8.

A first step 910 comprises operating bipole power transmission network 800.

A second step 920 comprises producing a high frequency voltage (current) signal from one pole periodically for between 1 to 2 seconds. The second step 920 also comprises recording the high frequency voltage signal measured at points P1HA, P1LA, P2LA, COMA and GA in the bipole power transmission network 800.

A third step 930 comprises determining if a first calculation P1HA + COMA + GA = 0.

If the second step 920 determines P1HA + COMA + GA = 0, a fourth step 940 is taken. The fourth step 940 comprises determining is the ratio of COMA and GA is equal to a pre-defined value. The pre-defined value may be determined based on network analysis of the healthy (i.e. non-faulty) system in normal operation. For example, network analysis may be performed either by mathematically or by simulations. The pre-defined value may be a single value or a pre-defined range of values. For example, if the ratio of COMA and GA does not fall within the pre-defined range, then a fault may be detected. If the fourth step 940 determines the ratio of COMA and GA is equal to a pre-defined value then the algorithm 900 returns to the second step 920. If the fourth step 940 determines the ratio of COMA and GA is not equal to a pre-defined value then the algorithm 900 detects that the fault is in the DMR conductor (i.e. Flt 3 in Figure 8).

If the second step 920 determines P1HA + COMA + GA ≠ 0, a fifth step 950 is taken. The fifth step 950 comprises determining if a second calculation P1LA - (COMA + GA) = 0. If the fifth step 950 determines P1LA - (COMA + GA) = 0 then the algorithm 900 detects that the fault is in Pole 1. If the fifth step 950 determines P1LA - (COMA + GA) ≠ 0, the algorithm 900 detects that the fault is in Pole 2.

A sixth step 960 comprises taking a protective action involving disconnecting the faulty section of the DC circuit or reconfiguring the system in the event of detecting a fault. The scheme is therefore restored in normal operation using the new circuit configuration whilst the faulty section of the DC circuit is being repaired.

It should be noted that certain of the steps depicted in the flow diagram of Figure 9 and described above may be omitted or such process steps may be performed in differing order to that presented above and shown in Figure 9. Furthermore, although all the process steps have, for convenience and ease of understanding, been depicted as discrete temporally-sequential steps, nevertheless some of the process steps may in fact be performed simultaneously or at least overlapping to some extent temporally.

Apparatus, (including the means for generating 505, means for measuring 510, means for detecting 520 in Fig. 5; means for generating 71, means for measuring 73, means for detecting 79 in Fig. 7) for implementing the above arrangement, and performing the method steps to be described above (e.g., with respect to Figure 6), may be provided by configuring or adapting any suitable apparatus, for example one or more computers or other processing apparatus or processors, and/or providing additional modules. The apparatus may comprise a computer, a network of computers, or one or more processors, for implementing instructions and using data, including instructions and data in the form of a computer program or plurality of computer programs stored in or on a machine-readable storage medium such as computer memory, a computer disk, ROM, PROM etc., or any combination of these or other storage media.

Reference throughout this specification to an example of a particular method or apparatus, or similar language, means that a particular feature, structure, or characteristic described in connection with that example is included in at least one implementation of the method and apparatus described herein. The terms "including", "comprising", "having", and variations thereof, mean "including but not limited to", unless expressly specified otherwise. An enumerated listing of items does not imply that any or all of the items are mutually exclusive, unless expressly specified otherwise. The terms "a", "an", and "the" also refer to "one or more", unless expressly specified otherwise.

As used herein, a list with a conjunction of "and/or" includes any single item in the list or a combination of items in the list. For example, a list of A, B and/or C includes only A, only B, only C, a combination of A and B, a combination of B and C, a combination of A and C or a combination of A, B and C. As used herein, a list using the terminology "one or more of" includes any single item in the list or a combination of items in the list. For example, one or more of A, B and C includes only A, only B, only C, a combination of A and B, a combination of B and C, a combination of A and C or a combination of A, B and C. As used herein, a list using the terminology "one of" includes one, and only one, of any single item in the list. For example, "one of A, B and C" includes only A, only B or only C and excludes combinations of A, B and C. As used herein, "a member selected from the group consisting of A, B, and C" includes one and only one of A, B, or C, and excludes combinations of A, B, and C." As used herein, "a member selected from the group consisting of A, B, and C and combinations thereof" includes only A, only B, only C, a combination of A and B, a combination of B and C, a combination of A and C or a combination of A, B and C.

Aspects of the disclosed method and apparatus are described with reference to schematic flowchart diagrams and/or schematic block diagrams of methods, apparatuses, systems, and program products. It will be understood that each block of the schematic flowchart diagrams and/or schematic block diagrams, and combinations of blocks in the schematic flowchart diagrams and/or schematic block diagrams, can be implemented by code. This code may be provided to a processor of a general-purpose computer, special purpose computer, or other programmable data processing apparatus to produce a machine, such that the instructions, which execute via the processor of the computer or other programmable data processing apparatus, create means for implementing the functions/acts specified in the schematic flowchart diagrams and/or schematic block diagrams.

The schematic flowchart diagrams and/or schematic block diagrams in the Figures illustrate the architecture, functionality, and operation of possible implementations of apparatuses, systems, methods, and program products. In this regard, each block in the schematic flowchart diagrams and/or schematic block diagrams may represent a module, segment, or portion of code, which includes one or more executable instructions of the code for implementing the specified logical function(s).

It will be appreciated that numerical values recited herein are merely intended to help illustrate the working of the invention and may vary depending on the requirements of a given power transmission network, component thereof, or power transmission application.

The listing or discussion of apparently prior-published documents or apparently prior-published information in this specification should not necessarily be taken as an acknowledgement that the document or information is part of the state of the art or is common general knowledge.

Preferences and options for a given aspect, feature or parameter of the invention should, unless the context indicates otherwise, be regarded as having been disclosed in combination with any and all preferences and options for all other aspects, features and parameters of the invention.

**Claims**

1. A method for detecting a fault close to a grounding circuit in a high voltage direct current, HVDC, power transmission system, wherein the HVDC power transmission system comprises a first converter device having a first terminal and a second terminal, a second converter device having a third terminal and a fourth terminal, a transmission cable connecting the first terminal of the first converter device with the third terminal of the second converter device, and a neutral line connecting the second terminal of the first converter device with the fourth terminal of the second converter device, the method comprising the steps of:

generating an alternating current, AC, signal by a source converter device, such that a major portion of the generated alternating current signal flows through a direct current circuit, DC circuit, the DC circuit comprising a stray capacitance associated with the transmission cable and at least one return path, wherein the source converter device is either of the first converter device or the second converter device, wherein the source converter device is located electrically close to the grounding circuit;

measuring a respective current at each of a plurality of points in the HVDC power transmission system; and

detecting a fault electrically close to the grounding circuit based on the measured currents.

2. The method as claimed in claim 1, wherein the return path includes the stray capacitance of the neutral line and the grounding circuit under normal condition.

3. The method as claimed in claim 1 or claim 2, wherein the return path includes the stray capacitance of the neutral line, the grounding circuit, and one or more unintended ground paths under a fault condition.

4. The method as claimed in any one of claims 1 to 3, wherein the neutral line is a dedicated metallic return.

5. The method as claimed in any one of the preceding claims, wherein the alternating current signal is a high frequency signal having a frequency of $f=1/(2\pi\sqrt{LC})$, where L is a lumped inductance of the source converter device that generates the AC signal and the transmission cable, and C is a lumped capacitance to ground of the transmission cable.

6. The method as claimed in any one of the preceding claims, wherein the alternating current is periodically generated for a pre-defined time interval.

7. The method as claimed in the preceding claims, wherein the plurality of points in the HVDC power transmission system include the transmission cable, the neutral line, the grounding circuit, or a first neutral area of the at least one source converter device.

8. The method as claimed in claim 7, wherein a fault in the neutral line is detected based on a ratio of the measured currents in the neutral line and the grounding circuit.

9. The method as claimed in claim 7 or claim 8, wherein a fault in the first neutral area is detected based on a sum of at least the measured currents in the transmission cable, the neutral line and the grounding circuit.

10. The method as claimed in any preceding claim, wherein the HVDC power transmission system further comprises a third converter device and a fourth converter device arranged in a bipolar circuit with the first converter device and second converter device.

11. The method as claimed in claim 10, wherein the current is measured at a second neutral area associated with the third converter device or fourth converter device.

12. The method as claimed in claim 11, wherein a fault in the first neutral area or the second neutral area is detected based on the measured current in the first neutral area and the second neutral area.

13. The method as claimed in any preceding claim, wherein one or more of the measured currents is a harmonic current.

14. The method as claimed in any preceding claim, further comprising the step of performing a protective action upon detecting the fault.

15. An apparatus for detecting a fault close to a grounding circuit in a high voltage direct current, HVDC, power transmission system, wherein the HVDC power transmission system comprises a first converter device having a first terminal and a second terminal, a second converter device having a third terminal and a fourth terminal, a transmission cable connecting the first terminal of the first converter device with the third terminal of the second converter device, and a neutral line connecting the second terminal of the first converter device with the fourth terminal of the second converter device, the apparatus comprising:

a means for generating an alternating current signal by a source converter device, such that a major portion of the generated alternating current signal flows through a direct current circuit, DC circuit, the DC circuit comprising a stray capacitance associated with the transmission cable and at least one return path, wherein the source converter device is either of the first converter device or the second converter device, wherein the source converter device is located electrically close to the grounding circuit;
a means for measuring current at a plurality of points in the HVDC power transmission system; and
a means for detecting a fault electrically close to the grounding circuit based on the measured currents.

Figure 1

Figure 2

Figure 3

Figure 4

500

506

501

502

505

510

520

530

Figure 5

600

Generate AC signal through a DC circuit of
a source converter

610

Measure currents in DC circuit
at plurality of points

620

Detect a fault based on the
measured currents

630

Figure 6

Figure 7

Figure 8

900

910 — Bipole Operation With DMR

920 — Produce a high frequency voltage (current) signal from one pole periodically for 1-2 sec. Record high frequency measurement from CTs, P1HA, P1LA, P2LA, COMA, GA

930 — P1HA + COMA + GA = 0 —Yes— 940 — Is ratio of COMA and GA as pre-defined —Yes—

No

Fault is in DMR conductor

950 — P1LA − (COMA + GA) = 0 —Yes— Fault is in Pole 1

NO

Fault is in Pole 1

960 — Fault is detected, protective action has taken place to disconnect faulty section of DC circuit and DC circuit is re-configured

Scheme restored in normal operation with new circuit configuration and faulty section is under repair

Figure 9

Europäisches
Patentamt

European
Patent Office

Office européen
des brevets

# EUROPEAN SEARCH REPORT

**Application Number**

EP 23 19 8600

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 3 965 243 A1 (GENERAL ELECTRIC TECHNOLOGY GMBH [CH]) 9 March 2022 (2022-03-09) * paragraphs [0052] - [0072], [0105] - [0111] * * claim 1 * * figure 1 * | 1-15 | INV. G01R31/08 |
| X | US 4 638 245 A (MACPHEE COLIN A A [CA] ET AL) 20 January 1987 (1987-01-20) | 15 | |
| A | * column 1, lines 30-57 * * column 2, line 50 - column 3, line 7 * * column 3, lines 54-63 * * claims 1,7; figures 1,2 * | 1-14 | |
| X | EP 0 360 109 A1 (ASEA BROWN BOVERI [SE]) 28 March 1990 (1990-03-28) | 15 | |
| A | * column 4, lines 26-41 * * figure 1 * | 1-14 | |
| X | JP 2015 137865 A (JX NIPPON OIL & ENERGY CORP) 30 July 2015 (2015-07-30) * paragraph [0002] * * paragraph [0006] - paragraph [0008] * * claim 1 * | 15 | **TECHNICAL FIELDS SEARCHED (IPC)** G01R H02J |

The present search report has been drawn up for all claims

| Place of search | Date of completion of the search | Examiner |
|---|---|---|
| Munich | 8 February 2024 | Stussi, Elisa |

EPO FORM 1503 03.82 (P04C01)

## ANNEX TO THE EUROPEAN SEARCH REPORT
## ON EUROPEAN PATENT APPLICATION NO.

EP 23 19 8600

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2024

| Patent document cited in search report | | Publication date | Patent family member(s) | | Publication date |
|---|---|---|---|---|---|
| EP 3965243 | A1 | 09-03-2022 | CN | 116018737 A | 25-04-2023 |
| | | | EP | 3965243 A1 | 09-03-2022 |
| | | | US | 2023327427 A1 | 12-10-2023 |
| | | | WO | 2022049188 A1 | 10-03-2022 |
| US 4638245 | A | 20-01-1987 | CA | 1219634 A | 24-03-1987 |
| | | | US | 4638245 A | 20-01-1987 |
| EP 0360109 | A1 | 28-03-1990 | CA | 1321619 C | 24-08-1993 |
| | | | DE | 68915663 T2 | 12-01-1995 |
| | | | EP | 0360109 A1 | 28-03-1990 |
| | | | SE | 462244 B | 21-05-1990 |
| | | | US | 5117323 A | 26-05-1992 |
| JP 2015137865 | A | 30-07-2015 | NONE | | |

For more details about this annex : see Official Journal of the European Patent Office, No. 12/82